# EUROPEAN PATENT APPLICATION

(11) **EP 4 746 246 A1**
(43) Date of publication of application: **20.05.2026**
(21) Application number: 25460042.2
(22) Date of filing: 24.09.2025
(51) Int. Cl.: H02J 50/00, H02J 50/12, H02M 7/00, G06F 1/26

(54) **POWER SUPPLY SYSTEM FOR POWER ELECTRONIC SWITCH GATE CONTROLLERS**

(30) Priority: 16.11.2024 PL 45028024
(71) Applicant: Politechnika Gdanska, 80-233 Gdansk (PL)
(72) Inventor: Szczepankowski, Pawel, 83-010 Rotmanka (PL); Guzinski, Jaroslaw, 80-288 Gdansk (PL); Cichowski, Artur, 80-457 Gdansk (PL)
(74) Representative: Pawlowska-Bajerska, Justyna

(57) **Abstract**

The power supply system for power electronic switch gate controllers is characterised by the fact that the elements of the gate controller power supply system are hermetically sealed in a cylindrical housing made of insulating material (TI), and the empty spaces inside the gate driver power supply system are filled with insulating filler (WI), and at least one pair of transmitter boards (PN1, PN2, PNn) and at least one pair of receiver boards (PO1, PO2, POn) is an integral and inseparable part of this system, where the isolation distance (OIZO) is created by the insulating material (TI) with insulating filter (WI). The outer part of the system has the form of a ribbed insulating surface (FPI), similar in its cross-section to that of pole insulators used in electrical networks, and in the central part of the system there are the transmitter system (UN) and the receiver system (UO) converting electric energy, preferably via wireless transfer by known means, whereby the wireless transfer takes place between the transmitters (PN1, PN2, PNn) and the receivers (PO1, PO2, POn).

## Description

The invention refers to the power supply system for gate controllers of power electronic switches - the power supply system for power electronic switch gate controllers. This system finds application in power electronic converters working at high breakdown voltage relative to the grounded protective conductor that require a DC source which is galvanically isolated, safe and resistant to high voltages and environmental factors, such as dust and moisture, to supply power electronic switch gate controllers.

The systems described in the publication entitled "Stosowane metody zasilania i izolacji galwanicznej sterowników bramkowych tranzystorów mocy w mostkowych stopniach końcowych wzmacniaczy klas D i falowników" *(The applied methods of supply and galvanic isolation of power transistor gate controllers in bridge end-stages of class D amplifiers and inverters)* Jacek Jasielski, Stanislaw Kuta Science, Technology and Innovation (STI) Open Access Journal Sci, Tech. Innov., 2018, 2 (1), 31-41, include bootstrap layouts and configurations based on a self-charging charge pump which provide galvanic isolation. In systems of this type, galvanic isolation is obtained using blocking voltages of semiconductor elements. The inconvenience of this solution is that it limits the range of voltage isolation to low voltages. The application of these solutions in higher voltage systems requires the use of very expensive semiconductor components, but still, the level of isolated voltages is limited, as the known semiconductor elements have limited blocking voltages. Moreover, the solutions presented in that publication reveal very limited resistance to environmental influences, as they are built in the form of electronic printed circuit boards, on which moisture and duct can settle, causing possible voltage breakdowns and system damages.

The aim and goal of the invention was to provide a power supply system for power electronic switch gate controllers which will ensure high voltage isolation and hermeticity, while maintaining simple design, to provide a DC source which is galvanically isolated, safe and resistant to high voltages and environmental factors such as dust and moisture, to supply power electronic switch gate controllers - DC electricity source for gate controllers of power electronic switches.

The power supply system for power electronic switch gate controllers comprising a transmitter system converting the DC energy supplied from an external source to the AC energy delivered to the transmitters, from which, based on the wireless charging principle, it is passed to the receivers, then converted in the receiver system from AC to DC energy, and finally passed further to the external circuit of the power electronic switch gate controller according to the invention, is characterised by the fact that the entire power supply system for gate controllers is hermetically sealed in a cylindrical housing made of insulating material, and the spaces inside the gate controller supply system are filled with insulating filler. At least one pair of transmitters - transmitter boards, and receivers - receiver boards is an integral and inseparable part of the system, where the isolating distance is created by the insulating material with insulating filler, such as polyurethane resin. The outer part of the system has the form of ribbed insulating surface with the cross-section similar to that of pole insulators in electrical networks, while in the central part of the system there are the transmitter system and the receiver system converting the electrical energy via wireless transfer.

Preferably, the transmitter-receiver pairs are spatially distributed on the side surfaces of two cylinders arranged coaxially to each other, thus creating a two-surface shape, and the number of transmitter-receiver pairs and their angular share in the filling of cylindrical surfaces is at least two.

Preferably, electronic components on the printed transmitter circuit board are connected in such a way that they form a single-phase voltage inverter built in bridge configuration by connecting field effect transistors, preferably four, and at the transmitter system input there is the voltage measurement system with a filter capacitor and at its output there is another voltage measurement system, both connected to the transmitter control system, and on one of the output poles of the transmitter system there is a resonant capacitor connected in series which forms a resonant system with its own inductance and the inductances of the transmitter boards.

Preferably, the receiver system consists of rectifier diodes, preferably four, accompanied by the filter capacitor, and the receiver system terminals are connected to the terminals of the receiver cable passing further the electrical power to the gate systems of power electronic switches.

More detailed description of the invention
In the power supply system for power electronic switch gate controllers according to the invention, the role of the isolation break is played by plastic whose properties and shape determine the system resistance to electrical breakdown. This plastic is a filler of power supply cubic capacity which performs both isolating and dust-proof functions. The outer part of the system has the cross-section shape similar to that of pole insulators used in electrical networks, thus ensuring a reduction in the level of epidermal discharge phenomena, in particular the formation of an electric arc. However, it differs from a typical pole insulator in that in the centre of the system there is a special converter, i.e. a transmitter system that converts electrical energy via wireless transfer. The system has a unique, more optimal shape of the electromagnetic wave absorption and emission surfaces between the transmitter system and the receiver system, consisting of pairs of transmitter and receiver surfaces placed on a cylinder at angular intervals resulting from the required amount of power to be processed by a given transmitter-receiver pair. In the previously known solutions, the transmitter system and the receiver system were two similar in size or even identical flat surfaces. The cylindrical shape of the power supply applied in the invention, with optimally shaped quasi-cylindrical pairs of wireless charging coils is characterised by a small volume which enables its easy installation in cable tracks of devices with gate controllers. Corresponding pairs of transmitter surfaces and receiver surfaces used in the invention can work independently, thus increasing the level of component redundancy of the entire power system and its utility by providing a possibility to obtain several voltage values. The structure according to the invention makes it possible to achieve high-class voltage resistance, which exceeds the values of power supplies available on the market. Frequently, to obtain safe and required resistance, a number of standard power supplies had to be connected in series, which complicated the solution and made it expensive. What is more, the hermetic nature of the present system, in particular the housing and the filler, ensures its isolation from the environment and makes this solution resistant to shocks, dust, moisture, and pressure. Additionally, the solution according to the invention causes the system to be also isolated from the environment with conductive elements, and therefore, it will not be a source of ignition of gases, which enables its use in potentially explosive environments.

The subject of the invention is shown as an example of implementation in a series of figures, where Fig. 1 shows a cross-section of the gate driver power supply system, Fig. 2 shows the transmitter system wiring diagram, and Fig. 3 the receiver system connection layout.

### Example

The gate driver power supply components are hermetically sealed in a cylindrical housing made of insulating material TI, and the empty spaces inside the gate driver power supply system are filled with insulating filler WI made of known material.

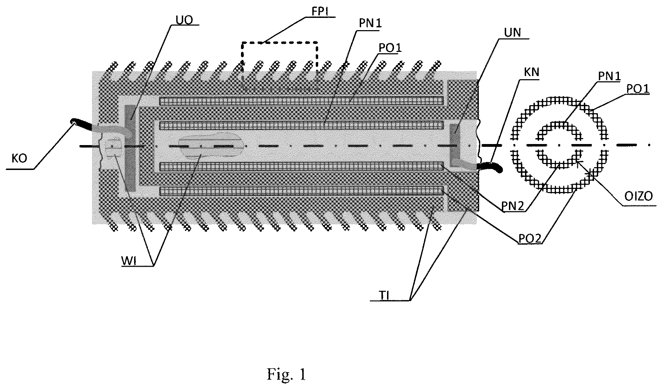

The power supply system for power electronic switch gate controllers is explained in more detail based on an example of implementation with two transmitter boards: the first transmitter board PN1 and the second transmitter board PN2, and two receiver boards: the first receiver board PO1 and the second receiver board PO2, working in parallel as shown in Fig. 1. The output voltage u_{nad} is connected to the parallel input terminals of the transmitter boards PN1 and PN2 - designations for the case of two boards - each of which has a high-frequency coil with the winding in the form of a single wire adjacent to the side surface of a half-cylinder and creating a spiral shape on it.

That is, in this example, the transmitter boards PN1 and PN2 - designations for the case of two boards - are coupled by a magnetic field with the receiver boards PO1 and PO2, which also have a similar spiral winding on their side surfaces. The boards have the form of surfaces.

In the case of more pairs of transmitters, designations: PN1, PN2, PN3, PN4, so i.e. PN1, PN2, PNn are used. Similar designations PO1, PO2, POn are used for receiver boards.

The power supply system for power electronic switch gate controllers is connected in series between the DC power supply and the power input to the power electronic switch gate system. The supply voltage for the described system is given to the terminals of the transmitter system UN using a two-wire transmitter cable KN, i.e. in the present case, a high-voltage electric cable shown in Fig.1.

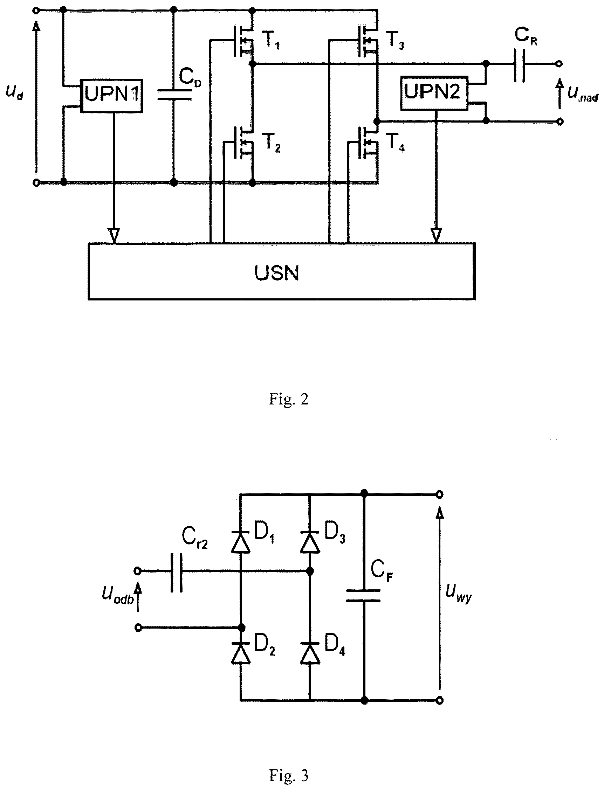

As shown in Fig. 2 and Fig. 3, in the gate driver power supply system the DC voltage u_{d} supplying the transmitter system UN is converted to high-frequency AC voltage and then to the rectified voltage u_{wy}, shown in Fig.3, which is given to the final receiver, i.e. the gate controller, using a two-core high-voltage receiver cable KO shown in Fig.1.

The negative and positive terminals of the transmitter KN are situated on the printed circuit board of the transmitter system UN, while the negative and positive terminals of the receiver cable KO are situated on the printed circuit board of the receiver system UO. As shown in Fig. 1, the cable terminals of transmitter KN and receiver KO are placed in the insulating filling WI to increase the cable resistance to voltage breakdowns. The transmitter system UN contains known electronic components connected in such a way that they form a single-phase voltage inverter built in bridge configuration shown in Fig.2 by connecting four field effect transistors T₁, T₂, T₃, and T₄ - the first, second, third and fourth field effect transistor T, respectively.

The DC voltage u_{d} given by the transmitter cable KN and terminals to supply the transmitter system UN is measured by the first measurement system UPN1, i.e. the measurement system for constant voltage u_{d}. The voltage at the output of the single-phase voltage inverter is measured by the second voltage measurement system UPN2. The outputs of both measurement systems, i.e. the first voltage measurement system UPN1 and the second voltage measurement system UPN2 are connected to the transmitter control system USN, as shown in Fig.2. In the transmitter system UN, at the input of the single-phase inverter bridge circuit there is the first capacitor C_{D} filtering the DC voltage u_{d}. The field effect transistors T1, T2, T3 and T4 - the first, second, third, and fourth field effect transistor T, respectively - are switched on and off alternately in pairs; the first field effect transistor T1 with the fourth field effect transistor T4, and the second field effect transistor T2 with the third field effect transistor T3, converting the voltage u_{d} to high-frequency AC voltage, which is measured using the second voltage measurement system UPN2. Alternate control of all field effect transistors T1, T2, T3, and T4, - the first, second, third, and fourth field effect transistor T, respectively - is executed by the transmitter control system USN, which controls the switching times and durations taking into account the voltages measured by the first voltage measurement system UPN1 and the second voltage measurement system UPN2. Therefore, UPN1 means the first system measuring the constant voltage u_{d,} and UPN2 means the second system measuring the voltage at bridge inverter output, i.e. the second measurement system.

On one of the output poles of the transmitter system UN, a resonant capacitor, - i.e. the first coupling capacitor C_{R} - is placed in series to create a resonant circuit with its own inductance and the inductances of the transmitter boards PN1 and PN2 - designations for the case of two transmitters - the pair. In the case of a pair, the boards have the form of two half-cylindrical surfaces with attached high-frequency coils, to which AC voltage u_{nad} is given. The output voltage, i.e. the AC voltage u_{nad}, is connected to parallel input terminals of the transmitter boards PN1 and PN2 - designations for the case of two boards - each of which has a high-frequency coil with winding in the form of a single wire adjacent to the side surface of the half-cylinder and creating a spiral shape on it.

The transmitter boards PN1 and PN2 - designations for the case of two boards - are coupled by a magnetic field with the receiver boards PO1 and PO2, which also have spiral windings identical to those on PN1 and PN2 on their side surfaces. The wires forming the windings on the boards of two transmitters PN1, PN2 and two receivers PO1, PO2 are situated opposite each other, thus creating adhering surfaces, between which the insulating material TI is placed to shape the form of a cylinder with the insulating distance thickness OIZO selected based on the assumed voltage resistance of the gate power supply system, taking into account the dielectric parameters of the applied insulating material TI. In the case of more pairs of transmitters than one, the following designations are used: PN1, PN2, PN3, PN4, i.e. PN1, PN2, ..., PNn. Similarly in the case of receiver boards, the designations: PO1, PO2, ..., POn are used. The receiver boards PO1 and PO2 are connected in parallel, and the ends of the wires spirally arranged on their surfaces are connected with the receiver system diode rectifier UO made of rectifier diodes D₁, D₂, D₃, D₄, i.e. the first, second, third and fourth rectifier diode D, respectively, 'which contains at its input the second coupling capacitor Cᵣ₂, being an element of the resonance circuit with the inductances of the windings on the receiver boards PO1 and PO2. In the diode rectifier of the receiver system UO, which acts as the receiver, the induced AC voltage u_{odb} is rectified into the receiver's DC voltage, i.e. the rectified voltage u_{wy}, using fast rectifier diodes D1, D2, D3, D4, i.e. the first, second, third and fourth rectifier diode D, respectively. The ripples in the waveform of the rectified voltage u_{wy} are smoothed out using a capacitive filter with the second filter capacitor C_{F}.

The entire power supply system for gate drivers is hermetically sealed in a cylindrical housing made of insulating material TI, the outer surface of which has a ribbed cross-section, similar to the shape of the ribs applied in high-voltage insulators used, for instance, in high-voltage transmission lines. The outer surface of the gate driver power supply system has been shaped in this way to reduce the risk of electric arc transmission due to surface discharges. The spaces inside the gate driver power supply system are filled with insulating filler WI, which ensures the dust-tightness of the design thanks to the use of the material with good breakdown voltage resistance and high heat conduction capacity.

### Nomenclature:

Designations in Fig.1 (systems used in the elements of the invention means "subsystem" so. elements in the invention - whole system):
KO - receiver cable (high-voltage two-core cable creating connection with the receiver, such as the gate driver for instance)
UO - receiver system (PCB with electronic components shown in the drawing marked as Fig.3)
FPI - form of insulating surface (housing with a special cross-section, used, for instance, in high-voltage insulators in the power industry)
PN1 - the first board of the first transmitter
PN2 - the second board of the second transmitter
PO1 - the first board of the first receiver
PO2 - the second board of the second receiver
UN - transmitter system (PCB with electronic components shown in the drawing marked as Fig.2)
KN - transmitter cable (high-voltage two-core cable creating connection with the source of DC voltage on the primary side, most often the so-called low voltage side, or the control system side)
OIZO - isolation distance (an important parameter, as the voltage resistance, the so-called breakdown voltage, depends on its size)
TI - insulating material (the form of insulating material which constitutes, by its structure, the insulating distance OIZO)
WI - insulating filler

Designations in Fig.2:
u_{d} - DC voltage supplying the transmitter system UN
u_{nad} - AC voltage applied to the transmitter boards PN1 and PN2
C_{D} - the first capacitor filtering the DC voltage u_{d} (this capacitance reduces ripples of the voltage supplied by the transmitter cable KN)
T₁, T₂, T₃, T₄ - the first, second, third, and fourth field effect transistor of the bridge inverter of the transmitter system UN, respectively
C_{R} - the first coupling capacitor of the transmitter system UN with transmitter boards PN1 and PN2
USN - transmitter control system
UPN1 - the first measurement system of DC voltage u_{d}
UPN2 - the second system of voltage measurement at bridge inverter output, the so-called second measurement system.

Designations in Fig.3:
u_{odb} - AC voltage from the receiver boards PO1 and PO2
Cᵣ₂ - the second capacitor coupling the receiver boards PO1 and PO2 with z the diode bridge rectifier containing four fast switching diodes, the rectifier diodes D1, D2, D3 and D4, respectively.
u_{wy} - rectified voltage obtained from AC voltage u_{odb} at diode rectifier output, connected with the receiver cable KO
C_{F} - the second capacitor filtering the rectified voltage u_{wy}

The rectifier diodes are designated as D₁, D₂, D₃, D₄.

## Claims

1. Power supply system for power electronic switch gate controllers comprising a transmitter system that converts the DC energy supplied from an external DC source to the AC energy delivered to the transmitters, from where it is then passed to the receivers via wireless charging and converted in the receiver system from AC to DC current energy and further passed to the external power electronic switch gate driver, is **characterised in that** the elements of the gate controller power supply system are hermetically sealed in a cylindrical housing made of insulating material (TI), and the empty spaces inside the gate driver power supply system are filled with insulating filler (WI), and at least one pair of transmitter boards (PN1, PN2, PNn) and at least one pair of receiver boards (PO1, PO2, POn) are an integral and inseparable part of this system, where the isolation distance (OIZO), is created by insulating material (TI) with insulating filter (WI), preferably in the form of a polyurethane resin, while the outer part of the system has the form of a ribbed insulating surface (FPI), similar in its cross-section to that of pole insulators used in electrical networks, and in the central part of the system there are the transmitter system (UN) and the receiver system (UO) converting electric energy, preferably via wireless transfer by known means, whereby the wireless transfer takes place between the transmitters (PN2, PN2, ..., PNn) and the receivers (PO1, PO2, ..., POn).

2. The system according to claim 1, wherein the transmitter-receiver pairs (PN1, PN2, PNn; PO1, PO2, POn) are spatially distributed on the side surfaces of two cylinders arranged coaxially to each other, thus creating a two-surface shape in the form of two surfaces, whereby each transmitter-receiver pair has its angular contribution to these side surfaces, and the number of transmitter-receiver pairs is at least two.

3. The system according to claim 1 or 2, wherein the transmitter system (UN) comprises a printed circuit board with electronic components connected in such a way that they create a single-phase voltage inverter built in bridge configuration by connecting field effect transistors, preferably four, and at the input to the transmitter system (UN) there are the first voltage measurement system (UPN1) and the first filter capacitor (C_{D}), while at its output there is the second voltage measurement system (UPN2), where both voltage measurement systems (UPN1, UPN2) are connected to the transmitter control system (USN) and on one of the output poles of the transmitter system (UN) a resonant capacitor (C_{R}) is placed in series to create a resonance circuit with the self-inductance of the transmitter boards (PN1, PN2, PNn).

4. The system according to claim 1-3, wherein the receiver system (UO) comprises the rectifier diodes (D), preferably four, accompanied by the filter capacitor (C_{F}), and the terminals of the receiver system (UO) are connected to the terminals of the receiver cable (KO) passing further the electrical power to the power electronic switch gate systems.

5. The system according to claim 1-4, wherein the pair of transmitters and the pair of receivers have the form of boards.
